# EUROPEAN PATENT APPLICATION

(11) **EP 3 026 606 A1**
(43) Date of publication of application: **01.06.2016**
(21) Application number: 14195321.6
(22) Date of filing: 28.11.2014
(51) Int. Cl.: G06Q 10/06, G06Q 50/04, G06Q 10/10

(54) **A common plant model for modelling of physical plant items of a production plant**

(71) Applicant: Siemens Aktiengesellschaft, 80333 München (DE)
(72) Inventor: Altare, Giampiero, 1643 Genova (IT); Bortoloso, Luca, 16151 Genova (IT); Braun, Ulrich, 90431 Nürnberg (DE); Cereghino, Marco, 16147 Genua (IT); Doria, Francesca, 16132 Genova (IT); Jandl, Klaus, 7000 Eisenstadt (AT); Rossi, Gianluca, 16166 Genova (IT); Thurau, Oliver, 67117 Limburgerhof (DE)
(74) Representative: Maier, Daniel Oliver

(57) **Abstract**

It is the objective of the present invention to provide a common plant model for the MES, SCADA and DCS systems of a production facility benefitting from an integration architecture which enables a stringent and persistent modelling of the physical resources of the production facility for all type of systems (MES, SCADA, DCS) that attach to the common plant model.

This objective is achieved according to the present invention by a common plant model for modelling of physical plant items of a production plant within a manufacturing execution system having an engineering environment and a runtime environment, comprising:
a) a node type model aggregating different aspects for the modelling of a single physical plant item comprising public interface parameters as well as automation parameters;
b) a number of nodes, each representing an instance of one distinct node type;
c) a library model comprising a project library and a global library, said libraries comprising the node type model, a facet model and a rule model as well as a hierarchy model,
d) a wiring chart model defining the interaction between interface members of different facets of a node; and
e) a graph model representing physical and/or logical connections between the nodes.

This common plant model therefore provides a standardized architecture for the modelling of the physical plant items which can be used by a plurality of different user that are in a business relation to the physical plant items. In particular, the SCADA system and the DCS system have now access to the distinct modelling of their individual needs within the environment of the MES which is with respect to the execution and the control of the production of the plant the predominant system.

## Description

The present invention relates to a common plant model for modelling of physical plant items of a production plant within a manufacturing execution system having an engineering environment and a runtime environment.

As it is well known, a method for manufacturing processes planned by an Enterprise Resource Planning (ERP) and produced by a shop floor, provides a Manufacturing Executing System (MES) for modeling, planning, scheduling and implementing the manufacturing processes and controlling the corresponding production steps at plant floor level. In the automation pyramid consisting of Level 0 to Level 4, the ERP system resides on the highest level at Level 4 which represents the enterprise level taking care for a rough production planning and purchase order processing. The MES system is located at level 3 representing the plant control level comprising the detailed production modelling, planning, production execution, production data acquisition, KPI calculations, resource and quality management. The process control level is located at level 2 and comprises SCADA systems (Supervisory Control and Data Acquisition) which are used for the controlling and observation of the production, the administration of production recipes and the archiving of the production data. At level 1 which represents the field level process signals and I/O modules as well as the fieldbus are located thereby offering the interface to the technical production process via I/O signals. At level 0 representing the actuator/sensing level fast data collection of predominantly binary signals is typically fulfilled. Of course, the border of the divers levels are floating according to the set-up and circumstance of the respective production facility (plant).

In particular, an Enterprise Resource Planning System - hereinafter referred to as ERP - is a system including hardware devices and corresponding software applications for planning the business resources of an enterprise, i.e. material provisions, human resource managements, purchasing, orders, profits, finance, inventory controls, customer managements, etc., while the term "shop floor" at level 0 and 1 has been used to indicate a system supporting the control of single machines performing production actions and being involved in the manufacturing processes, for example by measuring the number of pieces produced per hour by each machine or the functioning parameters thereof, the quality of the pieces produced and so on.

A Manufacturing Execution System - hereinafter referred to as MES - is an intermediate layer at level 3 providing computing machines and software tools between the ERP upper layer and the shop floor lower layer, including a software tool for production order management, which receives requests of production from the ERP, and a software tool for production modelling, which supports the phases of selecting and managing the resources to be involved in the manufacturing processes, i.e. employees, machines and materials, in order to realize a planned manufacturing process within required time constrains.

Therefore, manufacturing execution systems being regulated by the ANSI/ISA/95 standard require modeling plant equipment for both scheduling and controlling activities. Therefore, the productive process typically consists of production request which define a request for production for a single product. The predefined product is identified by a production rule, each of which is divided in many segment requirements that represent simple productive actions which are controlled by the MES.

Thus, a production request (could be also called operation request or work order) contains at least one segment requirement; even it spans all production of the product. A segment requirement contains at least on material produced requirement with the identification, the quantity and the units of measure of the product to be produced. Usually, in MES, the user would like to modify the quantity of the product to be produced due to various reasons, such as machine down time, shortage of material, absence of personnel.

Another critical problem for the MES is to react immediately to the operation schedules developed by the ERP. In this activity, the creation of work orders from the operation schedule is one of the most challenging tasks in the interaction of the MES and the ERP and should be therefore operated under the best performance circumstances possible. Typically, a work order is rather complex in terms of execution steps, resources and parameter that its creation from scratch is very time consuming and often not compatible with the mostly tight manufacturing schedules.

Considering only the very few demands on an appropriate software structure for an overall system being enable to exchange data between the divers levels of the automation pyramid, today's software systems available cannot satisfy these demands. Currently, each system ERP, MES, SCADA and DCS (Distributed Control System) comprise their own modelling tools for modelling the physical equipment resources and the respective hierarchies which are therefore not done in a homogenous and permeable way. Therefore, in engineering as well in runtime the integration between the products of these different levels is difficult and error prone due to the necessity of keeping different planning models aligned.

It is therefore the objective of the present invention to provide a common plant model for the MES, SCADA and DCS systems of a production facility benefitting from an integration architecture which enables a stringent and persistent modelling of the physical resources of the production facility for all type of systems (MES, SCADA, DCS) that attach to the common plant model.

This objective is achieved according to the present invention by a common plant model for modelling of physical plant items of a production plant within a manufacturing execution system having an engineering environment and a runtime environment, comprising:
a) a node type model aggregating different aspects for the modelling of a single physical plant item comprising public interface parameters as well as automation parameters;
b) a number of nodes, each representing an instance of one distinct node type;
c) a library model comprising a project library and a global library, said libraries comprising the node type model, a facet model and a rule model as well as a hierarchy model,
d) a wiring chart model defining the interaction between interface members of different facets of a node; and
e) a graph model representing physical and/or logical connections between the nodes.

This common plant model therefore provides a standardized architecture for the modelling of the physical plant items which can be used by a plurality of different user that are in a business relation to the physical plant items. In particular, the SCADA system and the DCS system have now access to the distinct modelling of their individual needs within the environment of the MES which is with respect to the execution and the control of the production of the plant the predominant system.

A further preferred embodiment of the present invention may provide the node type model that comprises:
a) a header providing an identity information of the node type;
b) a structure facet for high level representation;
c) optionally an automation facet for automation representation;
d) optionally one or multiple functional facets for different functional aspects;
e) optionally one or multiple wiring charts defining the relationship between the facets of two node connected by a wire;
f) optionally one to multiple node views providing a view to node data exposed by the structure facet. This node type is mandatory within all systems using the common plant model wherein the structural facet is a mandatory element representing the public interface of the node.

In order to satisfy more than one demand on a specific hierarchy of the node, the node types can be defined for dedicated levels within defined hierarchies. In particular, one or multiple hierarchy levels can be assigned to a node type, thereby enabling guidance in an engineering system to create nodes in a hierarchy at an intended level.

In order to enable an advantageous engineering on the node type and a re-use of diverse node type in terms of node type templates, the node types can be defined in the libraries and can comprise attributes that are consumed by external applications, used for data representation or for implementing business logic.

Preferred embodiments of the present invention are described hereinafter more detailed with reference to the following drawings which depict in:
- Figure 1: schematically an overview on the library model applied in the Common Plant Model;
- Figure 2: schematically an overview on the node type model applied in the Common Plant Model;
- Figure 3: schematically an overview on the facet model applied in the Common Plant Model;
- Figure 4: schematically an overview on the wiring chart model applied in the Common Plant Model;
- Figure 5: schematically a first example on a wiring chart developed according to the wiring chart model of Figure 4;
- Figure 6: schematically a second example on a wiring chart developed according to the wiring chart model of Figure 4;
- Figure 7: schematically an overview on the rule model applied in the Common Plant Model;
- Figure 8: schematically a third example on a wiring chart developed according to the wiring chart model of Figure 4;
- Figure 9: schematically an overview on the node model applied in the Common Plant Model;
- Figure 10: schematically the structure of a central repository within the Common Plant Model;
- Figure 11: schematically an overview on the hierarchy model applied in the Common Plant Model;
- Figure 12: schematically an overview on the hierarchy models according to the existing ISA-95 and ISA-88 standards;
- Figure 13: schematically an example for a hierarchy according to the hierarchy model shown in Figure 11;
- Figure 14: schematically a node template to be used for the creation of nodes according to the node model shown in Figure 9;
- Figure 15: schematically an overview on the group model applied in the Common Plant Model;
- Figure 16: schematically an overview on the graph model applied in the Common Plant Model;
- Figure 17: schematically an overview on the management of movable equipment (plant items) within the Common Plant Model;
- Figure 18: schematically an overview on an integration model to integrate DCS and SCADA hierarchies into the MES hierarchy according to the hierarchy model shown in Figure 11;
- Figure 19: schematically an overview on a collaboration model to integrate DCS and SCADA hierarchies into the MES hierarchy according to the hierarchy model shown in Figure 11;
- Figure 20: schematically an example for a hierarchical distribution of nodes to different runtime servers;

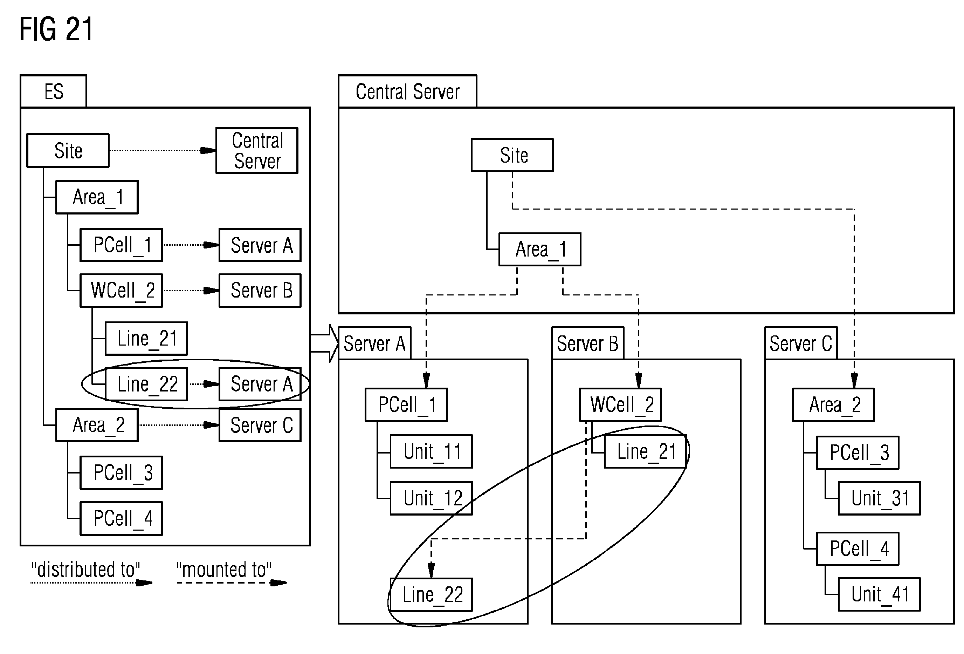

- Figure 21: schematically an example for a hierarchical distribution applying a single node selection;
- Figure 22: schematically an example on a non-hierarchical distribution of nodes which typically represents an DCS use case;
- Figure 23: schematically an overview on the runtime architecture and the integration of the Common Plant Model into an over-all plant architecture; and

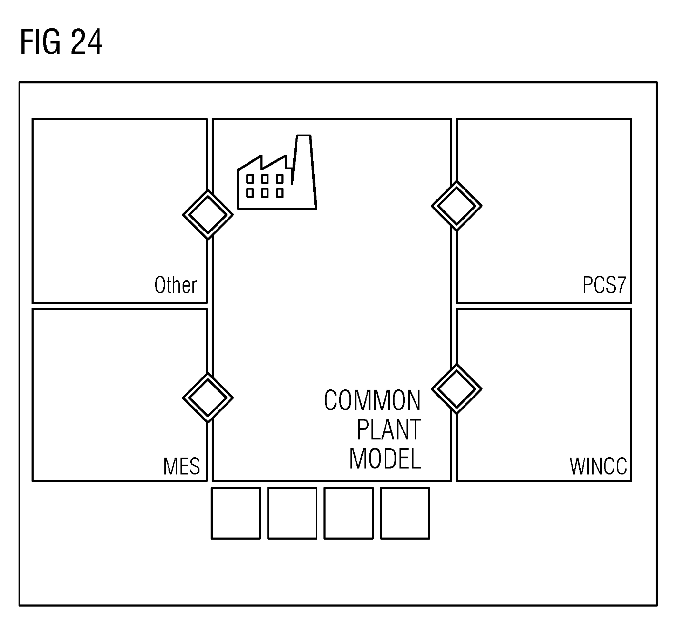

- Figure 24: schematically an overview on the common plant model and the applications using the common plant model.

In the following the object model of the Common Plant Model - hereinafter referred to as CPM - is described from a realization independent perspective. The general idea for the creation and application of the CPM is to adopt a single software platform for the control and execution of a production process wherein MES, SCADA and DCS+ system are assigned to distinct tasks within the usually very complex realization of the software platform customized for a distinct manufacturing plant. The customized software platform is hereinafter also referred to as project.

The CPM aims to model and organize each relevant item in the physical manufacturing plant. A physical plant item could represent fixed equipment, movable equipment, tools, assets, etc. This specification uses the term "CPM Node" for physical plant items. The objective of a CPM Node is to aggregate different aspects for the modeling of single plant physical elements. The aggregation involves the public interface parameters, as well as the automation parameters. All CPM Nodes are characterized by a set of common parameters (unique identifier, name, display name for multilingual support, description, etc.) and by an additional set which is specific for each node type (level for tank, temperature for the oven, availability for a press-machine). CPM Node parameters can be consumed by external applications (e.g. UI, OEE.), used for data representation or for implementing business logic.

The following table provides a brief description of the most frequent plant items:

**Table 1: Fehler! Kein Text mit angegebener Formatvorlage im Dokument.**

| **Type** | **Description** |
|---|---|
| | **Physical production equipment** |
| | (fixed location in the equipment hierarchy) |
| | Example: Mixers, reactors, assembly lines, etc. |
| | **Premises / Work centers** |
| **Plant structure** | Areas / Cells where physical equipment and other types of equipment are located. They sometimes need to be cleaned (e.g. for Life Science Industry) and maintained under specific environmental conditions. They are always "locations" for other resources. |
| Equipment modeled in an ISA-95 compliant hierarchy. | |
| | Example: Receiving area, Weighing room, Quality control room, and Sterile manufacturing room. |
| | **Storage equipment** |
| | Equipment where materials are stored (e.g. warehouse locations, buffer locations, tanks" etc.) |
| | **Virtual lines** |
| | Temporary organization of physical equipment for fulfilling a specific production. |
| **Movable equipment** | **Containers** |
| Equipment used to contain/transport materials. Containers can be moved between locations during | Any type of container, used to keep or move material. |
| | **Pallets** |
| | A particular type of container |
| manufacturing operations. | **Other movable equipment** |
| Tools can be attached on such equipment. | Movable tanks, AGVs, Forklifts |
| They can be attached to physical equipment. | |
| They can contain other movable equipment | |
| | **Instruments** |
| | They are not used to apply transformations, but they give measures and values on the product (e.g. balances and thermometers). |
| | **Tools** |
| **Auxiliary Tools** | They are used in operations to transform the product (e.g. filters, drills, mold for press machine and cutters). |
| Instruments, devices and tools used for executing manufacturing operations. They can be attached to equipment (fixed or movable). | **Workstation** |
| | The workstation represents the computer station from which the operator accesses to the applications. The workstation name is not the computer name on the network but is a logical name. |
| | The physical ID (computer ID) must be linked to only one logical ID (workstation name) |
| | **Printers** |
| | E.g. label printers |
| | **Additional devices** |
| | Any additional device that must be modeled in the system, whose properties have to be configured and used during manufacturing operations. |

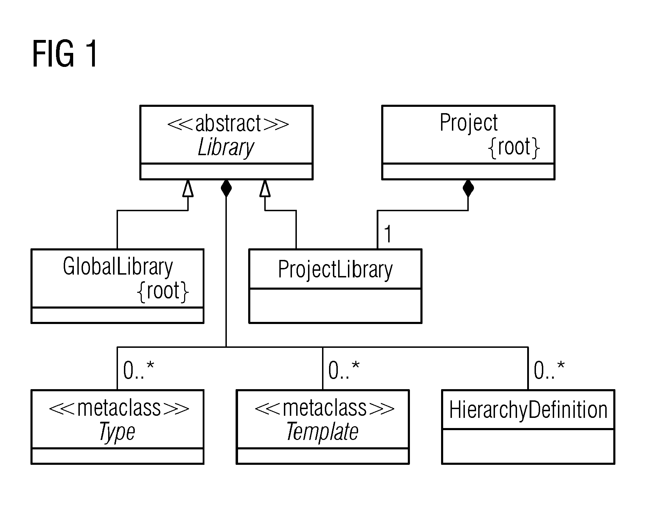

Figure 1 schematically shows a library model that is used in the CPM. A library according to this library model is an abstract object that has two concrete representations: a project library and a global library. A library generally comprises predefined objects that can be reused (i.e. types and templates and hierarchy definitions) as well as any objects serving as master copies. The CPM foresees two types of libraries as mentioned above:
- A *Global Library* is a project-independent library which can be used by several projects. A user can loosely couple global libraries to a project by means of the "shows" association. All thereby related global libraries can be used when working on a project. In practical Global Library aims to release product/industry specific Type definitions as explained hereinafter in more detail in order to meet a set of cross-functionalities (e.g. equipment types for food and beverage micro vertical industry).
- A *Project Library* is a unique part of a project. It contains all project master data. A *Project* aggregates one and only one *Project Library.*

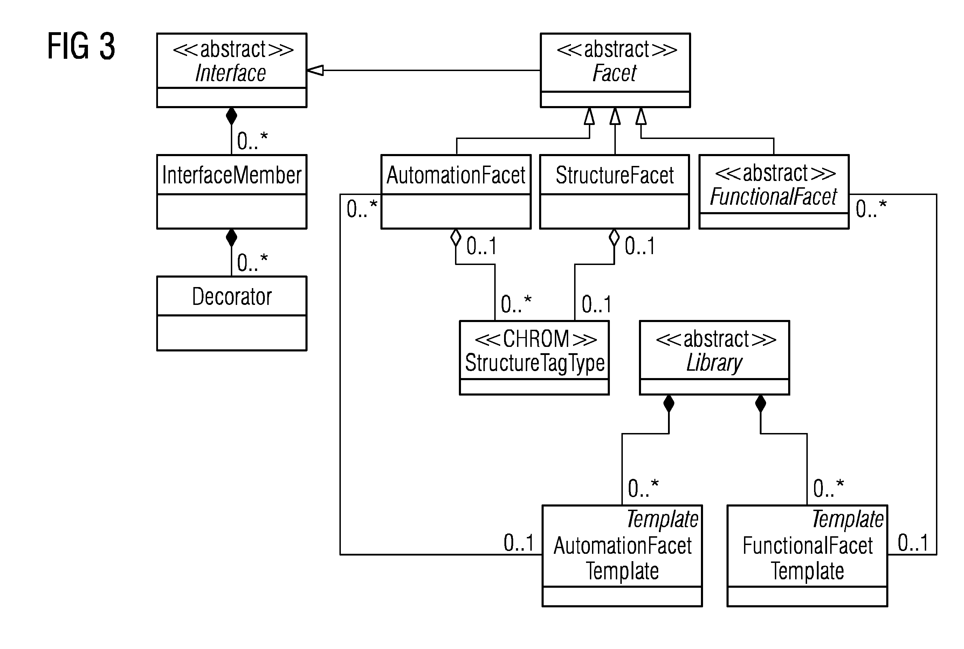

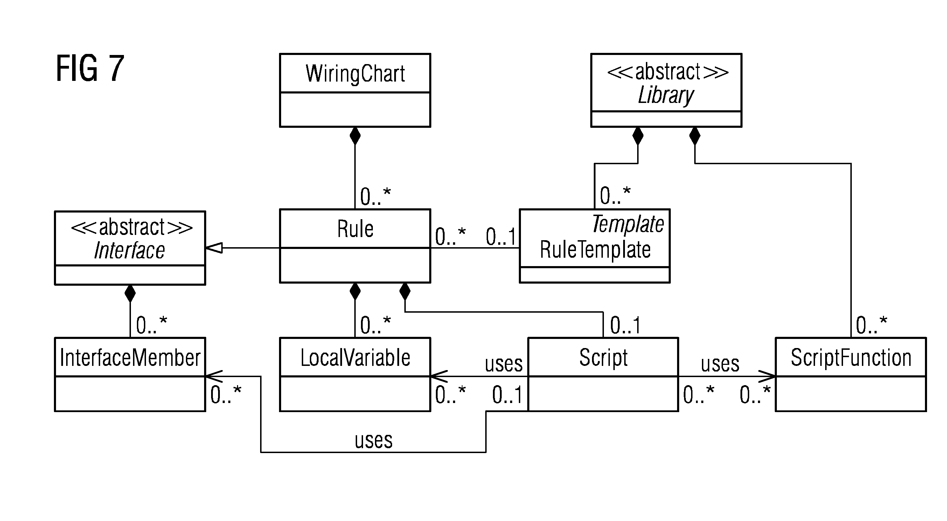

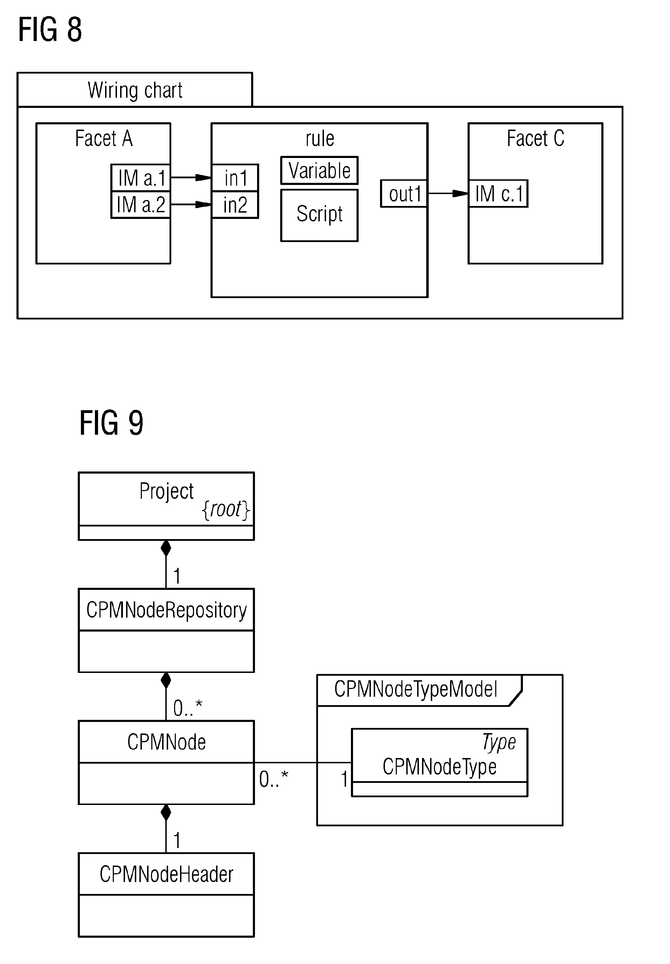

The objects that are comprised in a library are:
- Types, e.g. see CPM node type model explained later in Figure 9;
- Template, e.g. see facet model, rule model explained later in Figures 3 and 7 resp.
- Hierarchy definitions

The global library is provided by different automation specific products, such as MES, SCADA, DCS+, and can be specialized for micro-verticals (e.g. Food and Beverage, Automotive, etc.). Each global library is versioned.

The objective of a project library is to manage/contain all types and templates and their proper set of functionalities relevant for a dedicated customer project. The project library is versioned, too.

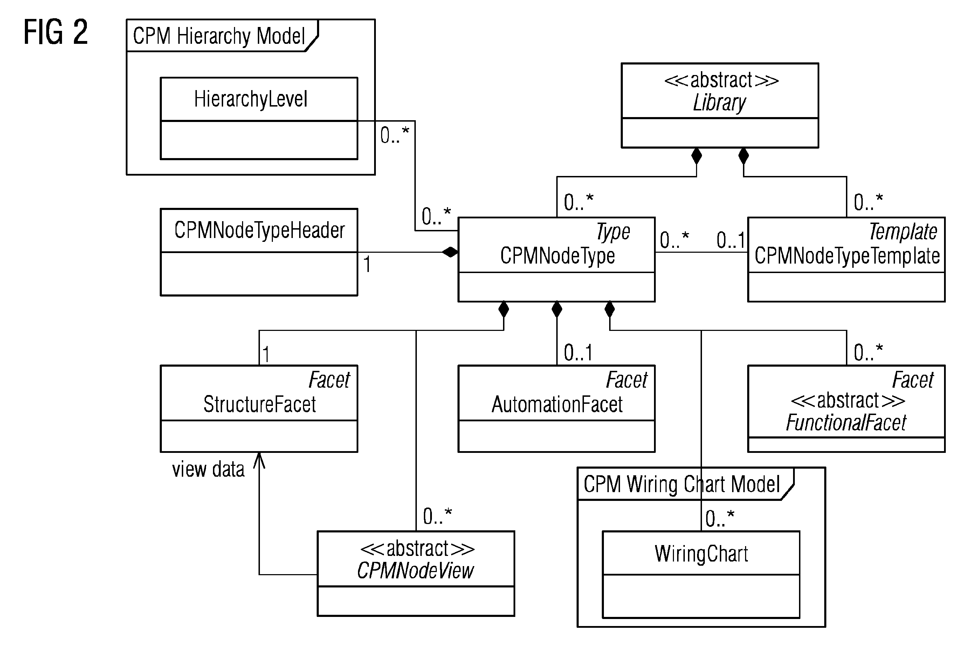

A CPM Node Type as schematically shown in Figure 2 and contained in a library, represents the main object type managed by the CPM and is used to model physical plant items. CPM Node Type comprises:
- Header, providing the identity information of the CPM Node Type (unique identifier, name, description, versioning, etc.)
- One Structure Facet for high level representation
- Optionally one Automation Facet for automation representation
- Optionally one or multiple Functional Facets for different functional aspects
- Optionally one or multiple Wiring Charts defining the relationship between the Facets
- Optionally one to multiple CPM Node Views providing a view to CPM Node data exposed by the Structure Facet, such as icon representation in plant displays, or so-called faceplates for detailed views.

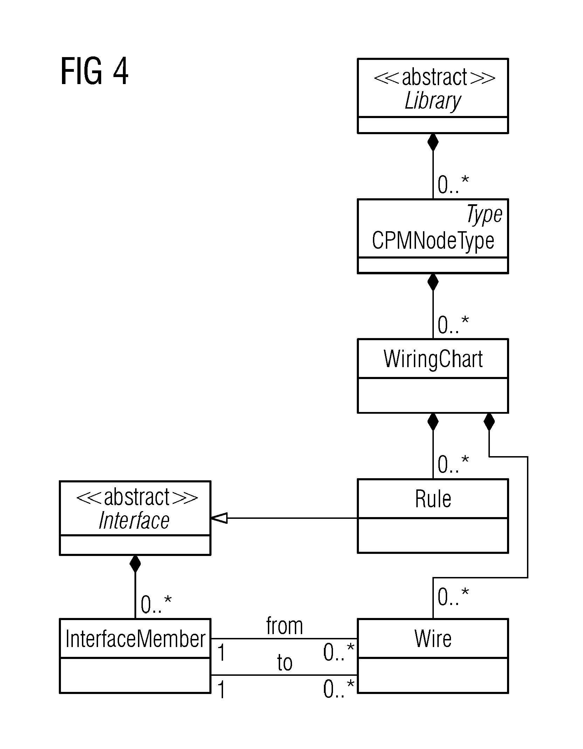

As it can be seen here for the description of the CPM node type model the facet model plays an important roll in the CPM object model and is therefore described later on with respect to Figure 3. More information regarding the wiring chart model is given with reference to Figure 4.

CPM Node Types can be defined for dedicated levels within defined hierarchies. Therefore, one or multiple Hierarchy Levels can be assigned to a CPM Node Type. This enables guidance in an engineering system to create CPM Nodes in a hierarchy at their intended level. CPM Node Type Templates support reuse of CPM Node Type template definitions for similar CPM Node Types inside a library. This increases ease of use in the CPM Node engineering workflow (e.g. creation and management of CPM nodes in the plant).

A CPM Node Type Header is defined as a set of information to uniquely identify a CPM Node Type. This information cannot be extended by users. The table below lists the relevant parameters:

**Table 2:**

| **Attribute** | **Description** |
|---|---|
| Identifier | Unique identifier for system-internal use only (not human readable) |
| Name | Canonical (mono-lingual) unique name used for name-based addressing |
| DisplayName | Multilingual display name used for UI |
| Description | Additional multilingual description |
| Version | Version information |
| IsMovable | Defines if the physical plant item (i.e. equipment) is movable |
| IsLocked | Protection flag in order to prevent node type modification |

Figure 3 schematically shows an overview on the facet model applied in the CPM. A Facet is designed to extend the CPM Node by exposing data and functionalities from different domains, related to the Facet scope, filtering and contextualizing them for the plant equipment. By means of a Facet, an external system is able to access to CPM Node information and enrich it by publishing proper business logic results (e.g. KPI calculation).

One of the most important facets is the Automation Facet which is a unique, but optional element intended as physical representation from the automation perspective. The Automation Facet relates to one or multiple Structure Tag Types in order to exchange data with the automation system. Thus, the Automation Facet in conjunction with a corresponding Structure Tag type acts like a wrapper to the automation system allowing to use the CPM Node Type for different automation system types.

At CPM Node instance level, the Automation Facet of the CPM Node relates to corresponding Structure Tag type instance inside the process image of the runtime system managing, controlling and executing the production process. Automation Facet Templates support reuse of Automation Facet template definitions for similar Automation Facets inside a library. This increases ease of use in the CPM Node engineering workflow.

The Structure Facet is a mandatory element representing the public interface of the CPM Node. Structure Facet defines the external CPM Node interface through the Interface Member that it exposes. External business logic or User Interface, through CPM Node structure facet, can:
- Read and write parameters of a CPM Node
- Define a subscription to a parameter of a CPM Node

The Structure Facet may optionally relate to a Structure Tag Type in order to exchange data with the process image for interface member value persistency. At CPM Node instance level, the Structure Facet of the CPM Node relates to corresponding Structure Tag instance inside the process image of the runtime system. Depending on the configuration of the Structure Tag, IOWA services may apply additional functionality such as alarm condition monitoring and/or data logging.

A Functional Facets optionally enrich the CPM Node with additional functional aspects. Examples for Functional Facets are:
- OEE: providing CPM node availability represented by any equipment by means "OEE Facet".
- Batch Control: assigns batch information to a CPM node representing a Unit via a "Batch Facet".
- Maintenance: calculation of operation hours, maintenance intervals by means of "Maintenance Facet".
- Material management: assigns material information including quantity to a CPM Node representing a storage location via a "Material Facet".

MES, SCADA and DCS products deliver their required Function Facets via their own libraries. The Functional Facet is a logical container providing data interfaces for exchange data coming from different products or system sources to the CPM. It allows loosely coupling between different existing systems that interact with the CPM, moreover allows systems working independently of each other in a way that if one of them is momentarily slow or unavailable it doesn't slow down or kill the entire system (loose coupling).

Another useful facet is called the CPM Node Proxy Facet which is mainly intended to enrich the CPM Node type with properties whose value is copied from the properties of CPM Nodes related to plants running in different projects with the scope of adding functionalities without changing the original configuration.

The CPM Node Type has one or more CPM Node Proxies with the ability to reference other CPM Nodes of the same or a different CPM Node Type.

A CPM Node Proxy Facet enables a CPM Node to access any defined property of the referenced CPM Node Type interface. In terms of communicating with another CPM Node (reading, writing, subscribing data values), a CPM Node Proxy Facet behaves exactly like an Automation Facet. As for other facets, a CPM Node Proxy provides an interface which can be used for inter-facet wiring at CPM Node Type level.

The usage of more than one CPM Node Proxy allows the separation of different concerns for different engineering roles (SCADA, MES and DCS). The engineering environment supports the definition of the CPM Node Proxy Facet properties at type and instance level by browsing the CPM Nodes running on the source CPM project. This implies that the engineering environment must be able to connect to the runtime systems (IOWA systems) of the source CPM project.

In case of a collaboration scenario, the engineering system supports the user in the creation of the "Mirror" CPM Node Types related to the part of plant that must be mirrored. Example:
- The User select the CPM node type in the source project.
- A CPM node type is created in the current project with the same name and containing:
- The same node members
   - A CPM Facet with the same members
   - a wiring chart that connect 1:1 the same CPM Facet and node members .
   - In this scenario, by default, the wire is one to one with no rule and, it is up to the user to decide whether the mirror of the equipment is complete or partial (i.e. some members of the node are removed along with the corresponding wires to the CPM Facet member).

The facet objective in general is to cover certain functionality (e.g. Automation System, Overall Equipment Effectiveness, Quality, Diagnostic, etc.) by offering a subset of data and functions filtered and configured for the CPM Node Type that is using it. Functional Facet Templates support reuse of Functional Facet template definitions for similar same or similar Functional Facets inside a library, e.g. the definition of an OEE or Material Facet which applies to a set of CPM Node Types within a library.

A Facet is an Interface that provides a set of Interface Members. Hence, each Facet is able to expose Interface Members. The table below lists the general information for interface member parameter definition:

**Table 3:**

| **Attribute** | **Description** |
|---|---|
| Identifier | Interface member identifier (it must be unique) |
| Name | Interface member name |
| DisplayName | Interface member multilingual name |
| Data type | Interface member data type |
| Direction | Interface member binding direction (input/output/input-output) |
| Read Only | It indicates if the interface member value cannot be modified by users during execution |

The Interfaces should accessible with a simple namespace string, something like mixerA.OEEFacet.Status.

A Decorator is an annotation that can be added to interface members. The purpose of the decorator is to extend the interface member. The interface member can be extended according to user specific needs. The table below lists the general parameters for decorator definition.

**Table 4:**

| **Attribute** | **Description** |
|---|---|
| Identifier | Decorator identifier (it must be unique) |
| Key | Decorator key |
| Data type | Boolean, Integer, String decorators supported. |
| Value | Decorator value |

CPM releases system decorators as well as offers the possibility to create new ones. Examples of default system decorator are listed in the following table:

**Table 5: Examples for default system decorators**

| **Decorator** | **Description** |
|---|---|
| HMIRelevant | Suggest that interface member is originally designed to be used for HMI system |
| NodeRelevant | Suggest that interface member is originally designed to be published within the structure facet |
| PIM | Suggest that interface member is originally designed to mirror back to Process Image (available only interface members belonging to structure facet) Restriction: Structure Facet only |

Parts of the Structure Facet are "mirrored" back to the process image to support alarming, logging, and other aspects of tags without the need to re-implement all these features in the CPM runtime.

Interface member decorator are available:
- At engineering for easier interface member manipulation.
- At runtime for detecting improper data manipulation or instance marshaling rules.

Example of decorator use can be:
- Read-only: value cannot be modified during execution, example: tank's capacity, equipment's mobility;
- Read-write: value can be modified during execution, example: quantity in the tank, sterilization status)

Figure 4 schematically shows a Wire Chart Model applied within the CPM. A Wiring Chart defines the interaction between Interface Members of different Facets. A Wire is drawn from one Interface Member to another. The Wiring Chart Model supports Rules in order the adapt values for Interface-specific needs.

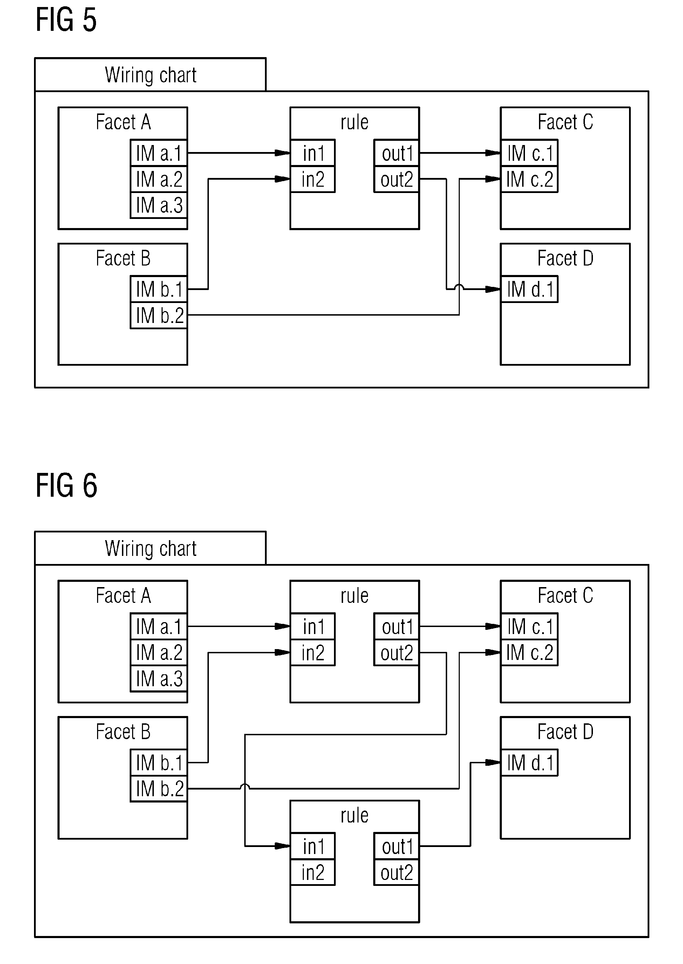

Figure 5 shows a first example for a Wiring Chart. If the interface members of two different facets don't require any data manipulation, the wiring is direct (e.g. IMb.2 → IMc.2). If the interface members, which belong to different facets, require data manipulation, the wiring is done by means of a mediator object called rule (e.g. IMa.1 → rule → IMc.1). This approach allows always specifying 1:1 connection between two interface members. The decoupling in two separate objects (rule and connection) allows writing reusable code, independent from the interface members and connection. Interface members connected by a wire must be of the same type of Interface members.

The wire bonding process is mainly used to propagate and align Facet parameters which are linked to a specific CPM Node. This aspect decreases the engineering effort and allows the engineer to re-use parameters already in place. Another aspect is data adaptation. The wire bonding process carried out by various kind of parameter: in case of a wired pair parameters needs some kind of data manipulation, a dedicated environment is offered to the Engineer to specify the conversion logic. The wiring is able to connect objects that expose their public interface as a list of interface members. A pair of interface member defines a Connection. The wiring connections and rules are organized within the wiring charts according to the Wiring Chart Model. The CPM Wiring Model, including wiring charts with rules and connections, is an optional part of the CPM Node.

A wiring chart has a list of rules and a list of connections. The wiring model is partitioned in several wiring charts in order to:
a) separate different project responsibilities (e.g. SCADA team and MES team working on the same CPM Node Type)
b) separate different product implementation (e.g. SCADA, MES, DCS) on the same project
c) manage complexity.

Since rule interface member and facet interface member are defined in the same way, it is possible to connect two or more rules using the same mechanism described in the previous paragraph as this is shown for a second wiring chart example in Figure 6. The connection from Facet A, IMb.1 goes via a first rule (upper box) and a second rule (lower box) to Facet C, IMc.2. Both rules can be engineered independently.

Figure 7 schematically shows rule model used within the wiring chart model which both are applied in the CPM. The Wiring rule is necessary when:
a) the wire between interface members requires any kind of data adaptation or manipulation in terms of rule.
b) More than two interface member have to be connected.

Just as the facets also the rule exposes itself by means of an interface members. The logic inside the rule is realized with a Script that can contain more than one Script Function. An authorized user can create a Script Function or use an existent one available in a Library. The script is meant to be stateless. In case of a state must be maintained between different of executions of the same rule a Local Variables must be defined. Because of rule is independent from connections and facet interface members, rules can be organized in libraries so that they can be reused as building blocks. Figure 8 schematically shows a third example for a wiring chart involving the mechanism of variable and script. The example of Figure 8 therefore can describe the following case:
- The wiring chart involves the facets Facet A and Facet C through the mediator RULE
- The variable within the rule contains the counter value
- The script within the rule updates the current counter value with the value of the interface member rule.1 if the machine status is active (rule.2 → 1)
- The Counter is reset when the machine status changes from 1 to 0 (Facet A.2 passes from 1 to 0)

Figure 8 now schematically illustrates the design of a CPM Node which represents the instance of the CPM Node Type. The CPM Node comprises a CPM Node Header which provides its identity information (unique identifier, name, description, versioning, etc.). A CPM Repository controls the lifecycle of each single CPM Node. A CPM Node instance inherits all its structures (i.e. Structure Facet, Automation Facet, certain Functional Facets, and Wiring Charts) from the CPM Node Type. The reference to the CPM Node Type is valid throughout the entire lifecycle in order to apply type changes at runtime to the CPM Node instance. The configuration engineer may overwrite properties at CPM Node level in order to apply distinct behavior to the instance. Such properties are default values such as set-points, value ranges, and CPM Node Views (in case that multiple ones are defined for a CPM Node Type).

In order to reduce complexity, wiring charts and rules are not subject for changes at instance level. The CPM Node can be further extended with user defined parameters in order to meet customer needs. The CPM Node Header is defined as a list of information which objective is to uniquely identify a CPM Node. The table below lists the relevant parameters:

**Table 5: CPM Node Header**

| **Attribute** | **Description** |
|---|---|
| Identifier | Identifier (it must be unique) |
| Name | Name |
| Display Name | Multilingual display name |
| Description | Additional description |
| Version | Version information |
| Hierarchy path list | Node path according to selected hierarchies |
| Target system | System field for distribution specification (e.g. CPMNode A1 will run on EV1) |
| Is Movable | It defines if the equipment is a movable equipment |
| Is Locked | Protection flag in order to forbid node type modification |

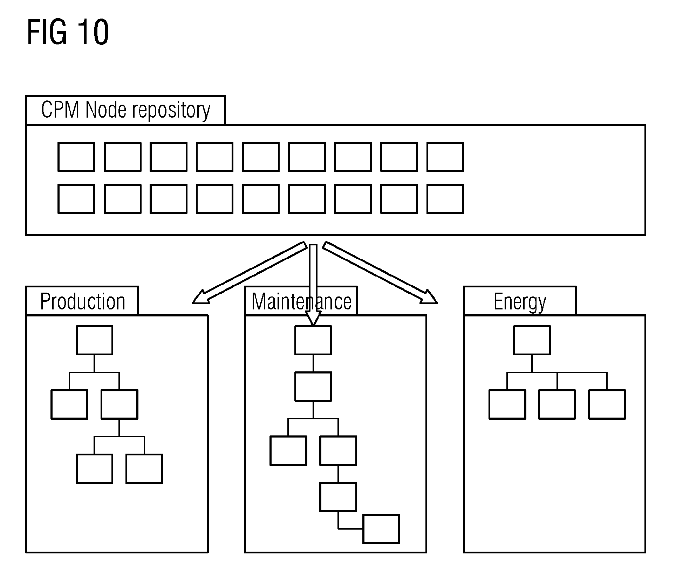

The CPM Runtime environment manages a flat node repository that contains all CPM nodes. The objective of the CPM Node repository is to manage the CPM Node life cycle. So that, each time a CPM Node/s is created or imported (bulk import), automatically its/their instance is managed independently from the possible hierarchies that the CPM node/s shall belong to. According to possible domain models (e.g. production, maintenance, energy), it is possible to organize nodes in different hierarchies as schematically shown in Figure 10.

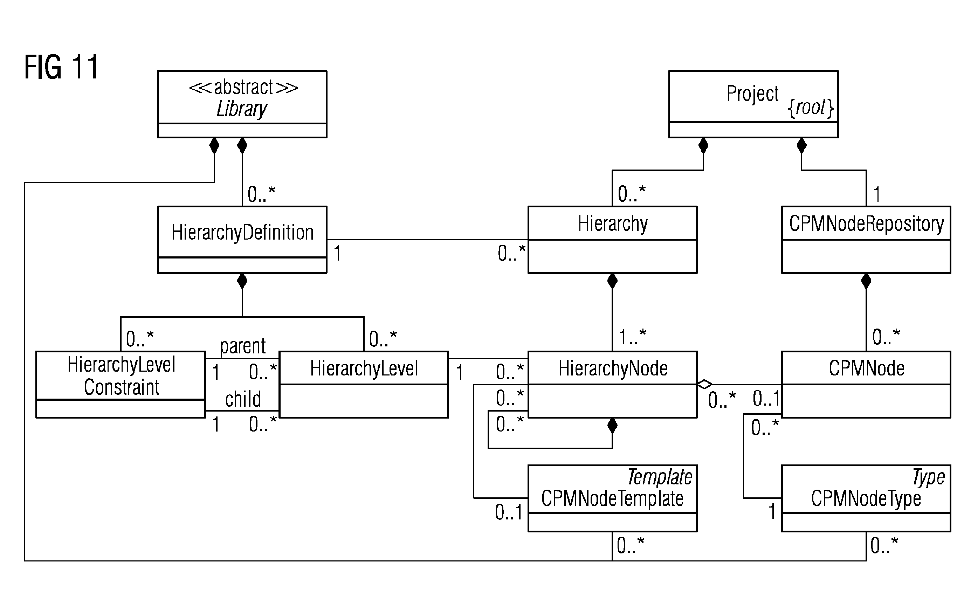

Another outstanding improvement of the CPM is realized by the Hierarchy model which is schematically shown in Figure 11. The CPM supports hierarchical object structures in order to organize equipment in different way in order to meet project and business process needs at the same time. This means that equipment (physical plant items) can be organized as a part of a production area. Similarly, the same equipment can be organized in a location structure where the objects fit into the physical/geographical context (e.g. it would show exactly where in the plant the Mixer is installed). Additional views could be defined by the user in order to organize the equipment for electricians, maintenance engineers so that they can work with appropriate views.

Hence, the objective of hierarchy definition is to define several organizations (that can have different level of details) so that the user can organize its equipment according to functional/physical/logical aspects. In addition it is possible to specify constraints when defining hierarchies' structure (e.g. an Area cannot contain a Site).

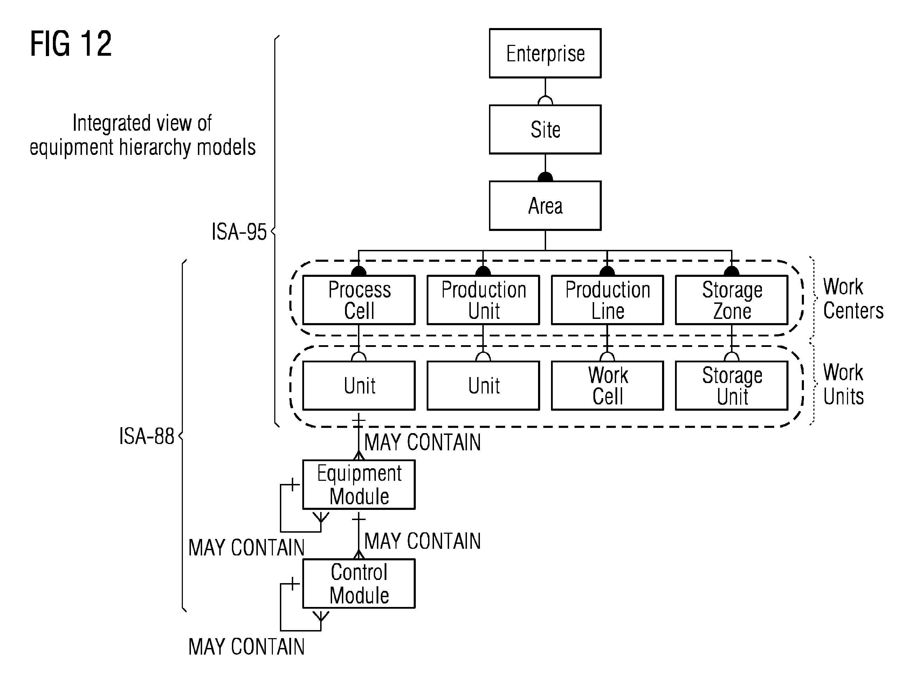

The aim of hierarchy model is to support hierarchically organized structures. The CPM nodes, which belong to a unique repository, can be organized in different hierarchies. Figure 12 shows an example of a combined view of ISA 95 and ISA 88 hierarchy models to describe the domain objects of the repository and the hierarchy. In this example Enterprise, site, area, work center, work unit are hierarchy levels.

Before a hierarchy can be built with CPM Nodes, it is necessary to specify a Hierarchy Definition. The engineering system can hide the need of Hierarchy Definition by means of default hierarchies (e.g. ISA 88/95, Parent-Child with no constrains). The Hierarchy Definition comprises the Hierarchy Levels and the relationship to each other via parent-child link of the Hierarchy Level Constrains.

The tables below show an example of Hierarchy definition:

**Table 6: Hierarchy entity definition - Hierarchy Definition**

| **Hierarchy Definition** | **Hierarchy Level** |
|---|---|
| Equipment Hierarchy | Site |
| | Building |
| | Line |
| | Machine |

The above table 6 lists the Hierarchy Levels for single Hierarchy definition (Equipment Hierarchy).

**Table 7: Hierarchy entity definition - Hierarchy Level**

| **Hierarchy Level** | **Parent Hierarchy Level** |
|---|---|
| Site | --- |
| Building | Site |
| Line | Building |
| Machine | Line |

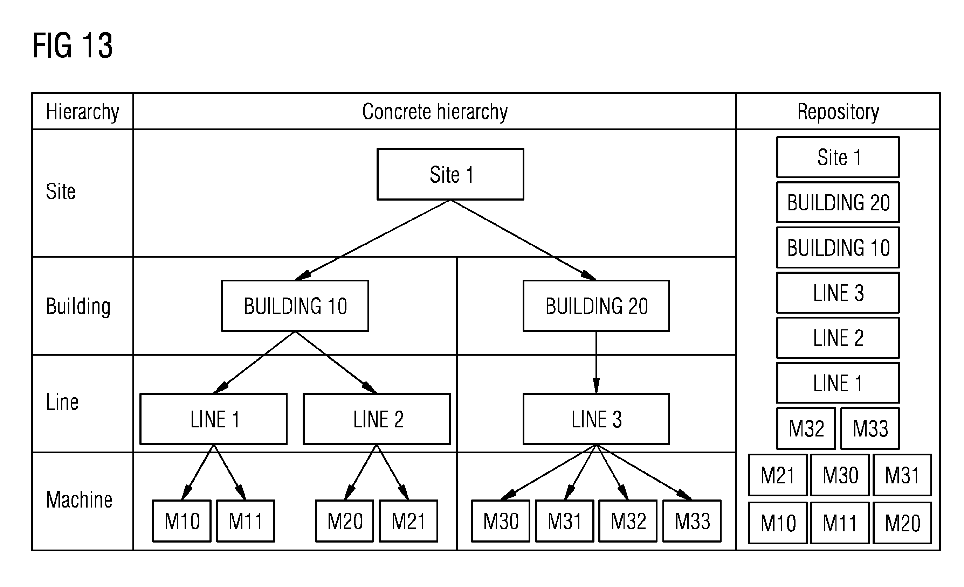

The above table 7 lists the Hierarchy Constrains among Hierarchy levels. The "concrete" hierarchy is built using the CPM Nodes available in CPM repository. This example is shown schematically in Figure 13.

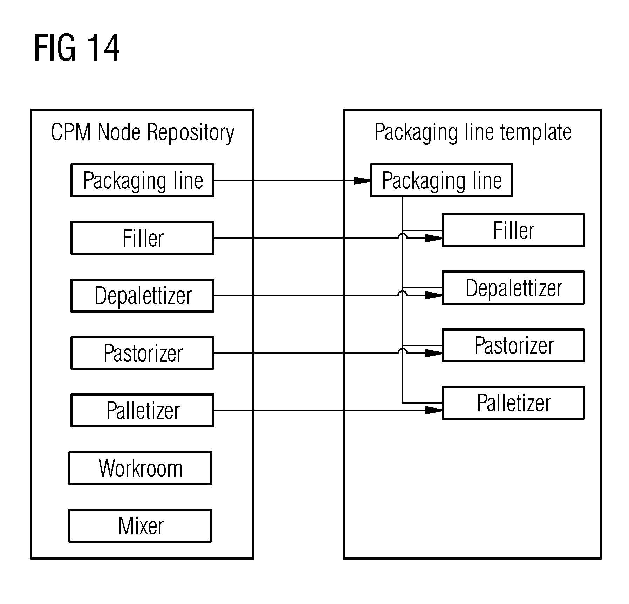

The CPM Node Template is created from instances and contains all information, including Automation and Functional Facet configuration, of these instances and hierarchy definition. From the practical point of view, the user is able to reuse a CPM Node Template to create multiple CPM Node instances. Depending on the template it could be a simple unit with few equipment modules or an entire Packaging Line. Figure 14 schematically illustrates an example of a packaging line, usually present in a bottling plant.

A Bottling packaging line template consists of a number of CPM Nodes, such as a:
- Filler,
- De-palletizer,
- Pasteurizer,
- Palletizer,

Each CPM Node contains its structure facet and MES functional facets which are relevant for the Bottling process. In case of multiple facets contained in one CPM Node, the CPM Node contains wiring charts, too. The CPM Node instances, which are created from a CPM Node Template, still maintain the reference to their CPM Node Types.

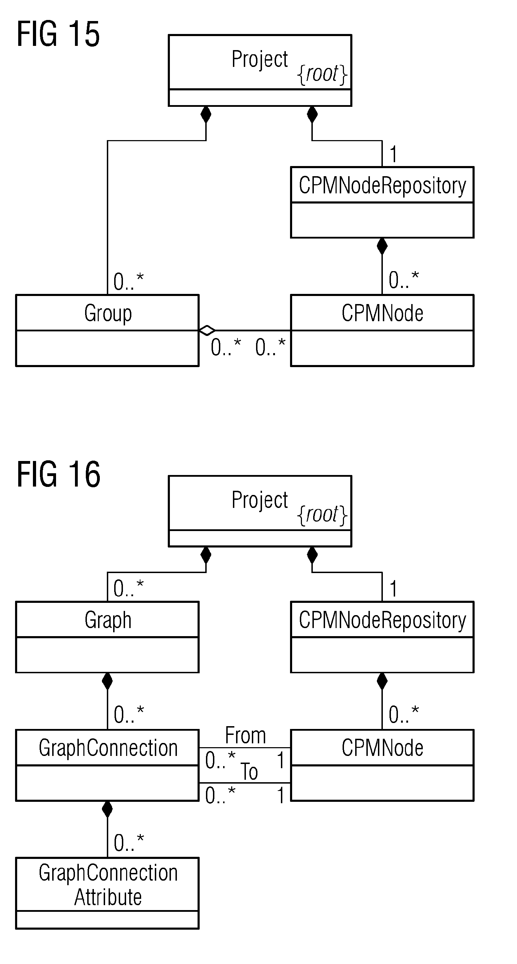

The group model schematically shown in Figure 15 allows a grouping of CPM nodes. This type of organization consists of grouping (statically or dynamically) a set of CPM Node both at engineering and at runtime phase. CPM Nodes can be manually added to a Group. A CPM Node can be assigned to multiple groups, too.

Typical examples are:
- group CPM Nodes that belong to the same ERP cost center;
- group CPM Nodes according to maintenance teams.

**Table 9: Group model**

| **Attribute** | **Description** |
|---|---|
| Identifier | Identifier (it must be unique) |
| Name | Name |
| Display Name | Multilingual display name |
| Description | Additional description |
| Version | Version information |

Figure 16 shows schematically the graph model applied in the CPM. The graphs are used to model the physical/logical connections between CPM Nodes. Each connection can contain an attribute list (time, cost etc.). The system recognizes all possible graphs by analyzing and filtering the connections among graph nodes.

The Graph model comprises:
- Graph: graph definition in terms of unique identifier, name and display name
- GraphConnection: a couple of CPM Nodes are linked via Graph Connection link
- GraphConnectionAttribute: each GraphConnection is further enrich with more than one attribute

As an example, a graph is used as a constraint for the routings definition (e.g. packaging line).

Movable equipment is an important and mandatory feature especially in process and pharmaceutical industry. Movable equipment is uniquely identified and has the same properties/features as a static CPM Node (Name, Description, Facets and proper Interface members, etc). In addition to that movable equipment is moved from one hierarchy position to another one.

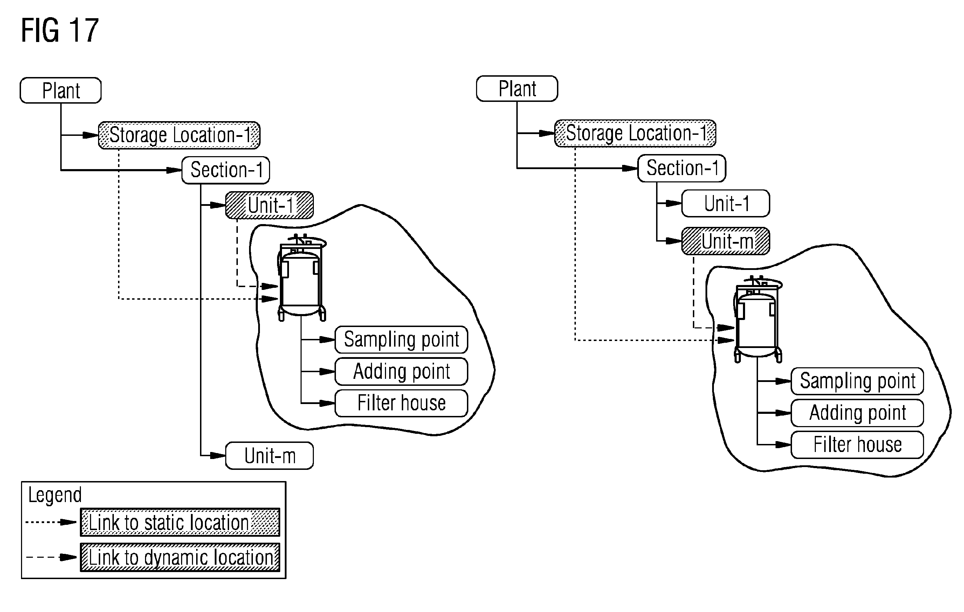

As for all other CPM Nodes, Movable equipment's life cycle is in charge of CPM Node Repository. From a hierarchical organization point of view, the Movable Equipment is
- assigned to a "Storage/Static location" (e.g. kitting area, Site etc.), see line for static location in Figure 17
- dynamically moved into new assigned location (in runtime move the equipment in the hierarchy), see line for dynamic location in Figure 17.
- "query-able" by path (hierarchical view) or by its general identity information by means of CPM Node Header
- addressable via path in the hierarchy showing current location
- With this concept, movable equipments can be addressed by fixed IDs (they will not be changed when the equipment moves) like:
   o CPM-Path of the storage static location
   o Unique Identifier
- And it can be addressed / shown by changing IDs:
   ∘ CNS-path to the location

In the following, integration and collaboration scenarios are explained in more detail. From the project implementation point of view, four different scenarios are foreseen:

### 1. Greenfield Top Down, implemented using SIEMENS® Portfolio:

Top down from plant design perspective means a brand new CPM project where the CPM node composition can be enriched in any time with functionality coming from different automation system products.

This does not imply that the commissioning is done for all products at the same time (e.g. SCADA can be commissioned before MES)

### 2. Greenfield Bottom Up, implemented using SIEMENS® Portfolio:

A CPM project is already in place and, in a second time, additional functionality is added. (e.g. MES project not designed in the first project phase and SCADA/DCS already in operation. CPM Nodes can be enriched with MES functions.

Please note that in case of regulated industries where the existing project is validated ("sealed"), there could be the case where a new validation is required or a "proxy CPM Node" has to be engineered (see scenario 3).

### 3. Brownfield Bottom Up, implemented using SIEMENS® Portfolio:

Different OEMs deliver part of the whole plant by means of independent CPM projects. In a second time, additional functionalities are requested on top of commissioned project. Example: MES on top of existing SCADA projects.

Unless there is an owner that takes the responsibility for changes the OEM system there is the need to create a new CPM project. The engineering effort could be mitigated if the source code of "sealed" project is available or "sealed" project structure can be only browsed for CPM project extension.

### 4. Brownfield ,Bottom Up, 3rd Party Systems:

In this case none of the strategies can be applied because of third party systems that do not conform to CPM model at all. Only interface level approach can be applied (e.g. OPC). For the above mentioned scenarios, the following two models shall be applied.

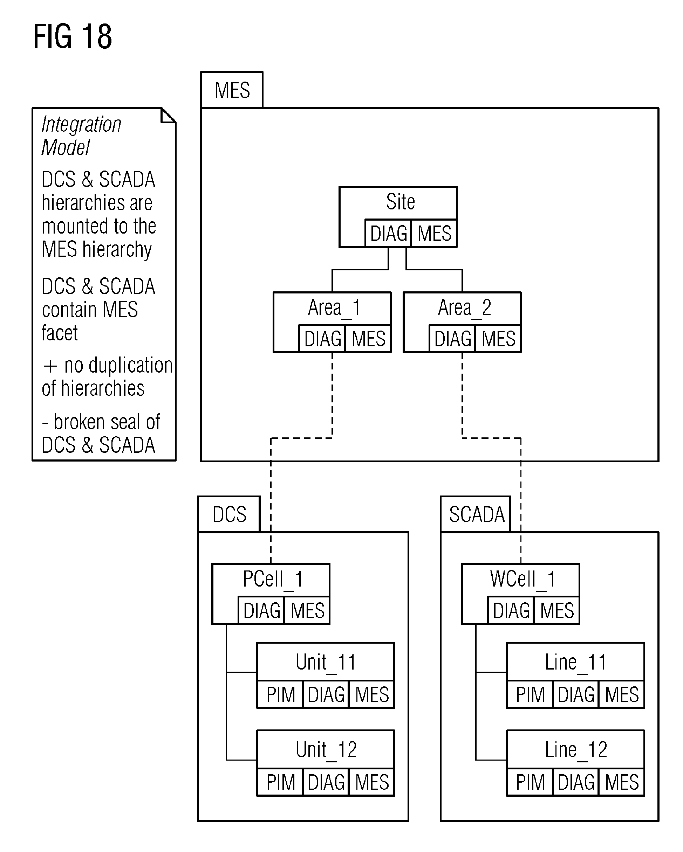

First model is the Integration Model which is schematically shown in Figure 18. The *integrated model* shall be applied in all not "sealed" systems. A "sealed" scenario is a system that cannot be modified from the engineering point of view. Typical example is a system released from OEMs which is a validated system in regulated industries. In order to implement an integrated scenario, the systems must not be treated as "sealed" in order to extend CPM Nodes with Functional Facets coming from different automation system products.

As a specific feature of the integration model, the hierarchies of the SCADA and the DCS system are mounted to the hierarchy of the MES. Therefore, both SCADA and DCS comprise in its specific nodes the facets from the MES. A duplication of the divers hierarchies is omitted which leads to a break on the seal of the SCADA and DCS system.

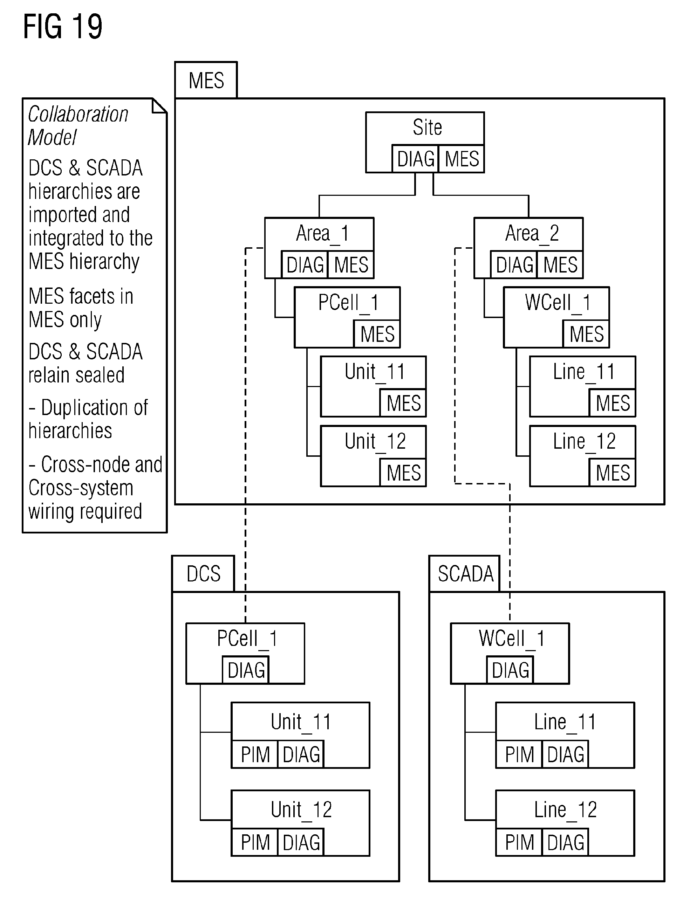

The second model is the collaboration model which is schematically illustrated in Figure 19. The collaboration model is the preferred model for application on all kind of "sealed" systems. Because the system cannot be modified from the engineering point of view, in the collaboration model exists the need to create proxy CPM Node (CPM node with attribute "proxy off" referencing CPM Node counterpart) representation of relevant objects of the sealed system. The system will provide transparent access to remote CPM Nodes belonging to the "sealed" system, but in the separated hierarchy. Non merger of hierarchy is done.

The engineering system shall support:
- Copying the hierarchy (selected parts) from the lower level systems to the upper level system
- Copying the structure facets (selected parts) from the lower level systems to the upper level system

In this scenario, value to the present solution of Siemens® can be added by the propagation of later modifications on the Sealed System and possibly applying consistency rules in order to alert on conflicts.

Therefore, in the collaboration model, the SCADA and DCS hierarchies are imported and integrated into the MES hierarchy (e.g. hierarchy according to ISA-95 and ISA-88). MES facets are exclusively used in the MES only which is completely different from the integration model. Both the SCADA and the DCS systems remain sealed and the respective hierarchies are duplicated as it can be seen in Figure 19 where the nodes of the SCADA and DCS systems are duplicated into the MES. In this regards, cross-node and cross-system wiring are required which means for example that MES facets have to be linked via the wiring to non-MES facets in the SCADA and/or DCS system.

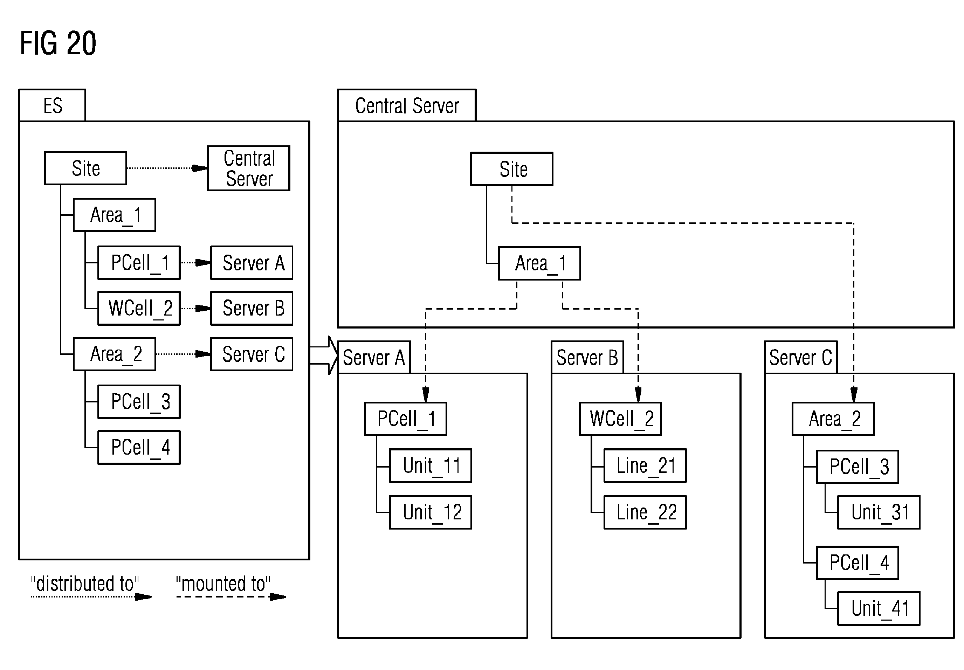

In the present example, a single dedicated Engineering Instance is in charge of configuring hierarchies, groups and graphs and how CPM nodes belong to them. The full CPM Node configuration is then distributed, kept aligned and locally cached in all server stations by means of the CPM Runtime and the IOWA Name Service. This Engineering Instance (engineering system ES) is responsible to send each runtime server its proper configuration as this is shown in Figure 20. If this runtime server is not accessible, the engineering system cannot download the new configuration to the target. A redundant configuration of the runtime server reduces the probability to not apply engineering changes as shown in Figure 20

The distribution of the CPM Nodes to different runtime servers is supported and it can be performed according to one or both of the following strategies.
1. Selecting higher a level hierarchy node containing relevant CPM Nodes from one of the hierarchies:
   - In case of distribution driven by a selected hierarchy, all child nodes of the selected parent node are distributed to the same target server station until a sub-ordinated node is distributed to another server.
   - Nodes not assigned to the distribution hierarchy may be highlighted to the user.
   - The central server can be a dedicated server station (as in the example) or even part of one of the "regular" server stations.
   - This approach enables easy engineering in terms of distributing the CPM.
2. Selecting single CPM Node from one of the Hierarchy This example is schematically shown in Figure 1. Even if the majority of CPM Nodes can be distributed according to the selection of a higher-level hierarchy node, certain, individual CPM Nodes may be distributed differently. Hence, the configuration engineer assigns single nodes to different systems (e.g. Line_22 to Server Station A). The configuration engineer configures one or multiple hierarchies, groups, and graphs and how CPM Nodes belong to them via a dedicated engineering system. The entire CPM Node configuration is then distributed to one or multiple runtime stations. This option enables high flexibility in terms of distributing the CPM.

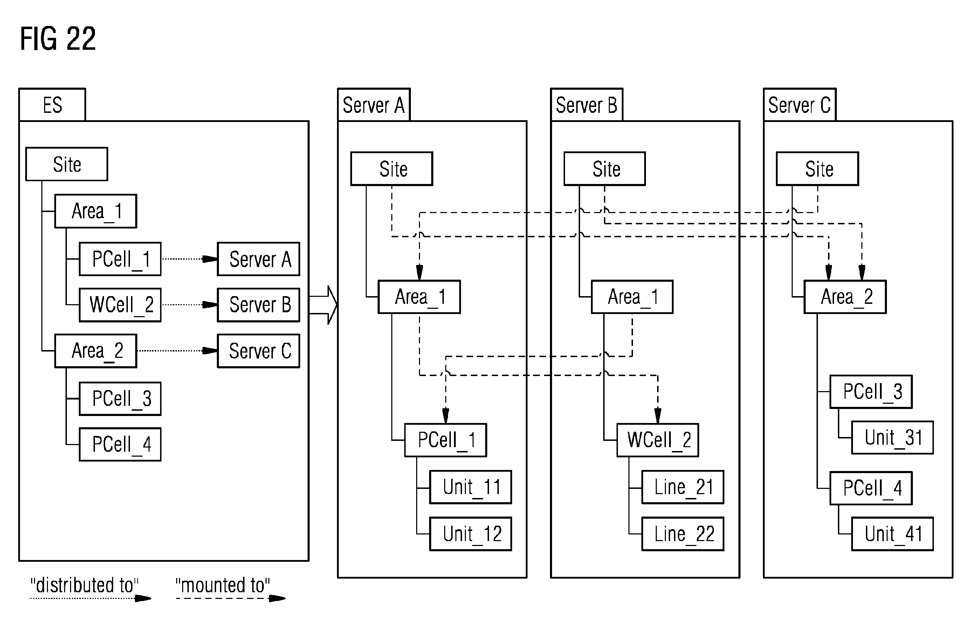

Non-hierarchical distribution as schematically shown in Figure 22 is a typical DCS+ use case. In contrary to the hierarchical distribution (see previous paragraphs) no dedicated runtime server station may exist as central server providing the common, higher-level hierarchy entity levels. A dedicated Engineering Station is in charge of configuring hierarchies, groups and graphs and how CPM nodes belong to them. The full CPM Node configuration is then distributed, kept aligned and locally cached in all server stations by mean of the CPM Runtime and the IOWA Name Service. This is necessary to provide a transparent view to the plant hierarchy to each client station, regardless to which server station a client station may be connected with. In this distribution mode, a dedicated runtime server exists as communication partner for the Engineering Station. If this runtime server fails, no parameterization is needed. Figure 22 therefore describes how the previous example configuration is distributed to three peer runtime stations:
- The Name Service of each runtime server represents the local process or work cell as well as "mounted" information concerning the process or work cells that have been distributed to the peer runtime stations. This is accomplished by means of so-called "mounted to" relations linking remote information to the local content.
- System spanning information of the "Site" entity is therefore available at each server station.
- A client station connected to any of the peer server stations is able to browse data of all peer server stations, hence the entire plant model, too.
- Each name service is able to provide references to local and remote objects, so that a client is able to access objects in a distributed system.
   ➢ This approach does not require a central server for a distributed CPM.

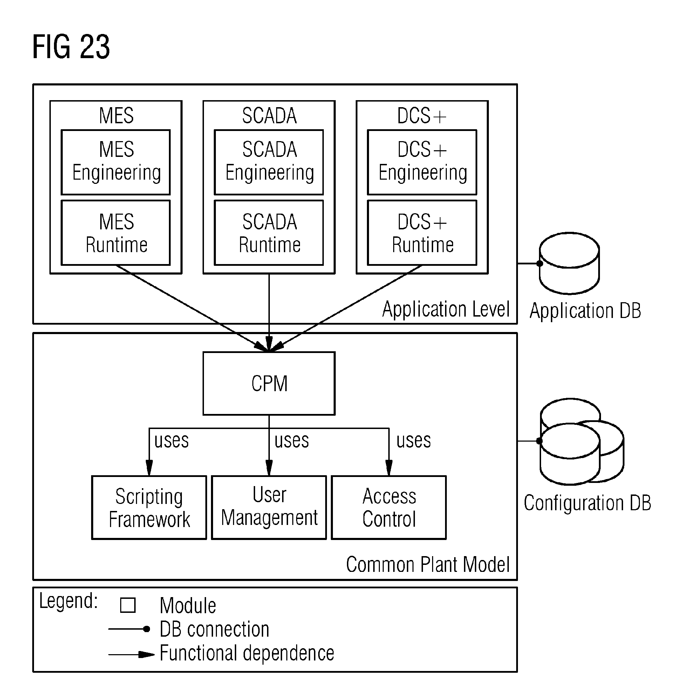

Figure 23 schematically illustrates how the CPM is integrated into an Over-All Architecture of the bundle of software applications which execute and control the manufacturing process in the plant (Runtime Architecture). Figure 23 therefore represents the relation between CPM and applications belonging to different products and the functional dependence of CPM from Scripting Framework (wiring chart execution engine), User Manager and Access Control component. Each single software system MES, SCADA and DCS+ now comprise both individual engineering and runtime systems which couple to the CPM. Therefore, none of these systems needs an individual system to model the production plan for its specific needs and demands. The engineering is therefore concentrated in the CPM which can be addressed from the engineering systems of the divers software applications (here MES, SCADA and DCS+). Each individual engineering specialist therefore bases his particular engineering work on the models described above and can therefore model his individual needs within the scope of models for the nodes, the facets, the rules, the wiring, the hierarchy and so on. Therefore, engineering now becomes completely transparent and permeable to all system engineers regardless for which specific software application they are working for.

### Glossary/Abbreviations

| **Term** | **Definition** |
|---|---|
| ADI | Simatic IT® data access interface |
| AGV | Automatic Guided Vehicle: Vehicles designed to transport goods, connecting different machines within the warehouse |
| Automation Facet | The automation facet is in charge of collecting all the structured tag types that the CPM Node needs for connection to automation system. |
| CPM | Common Plant Model as shown in Figure 24 |
| CPM Node | It represents the equipment instance. |
| CPM Node Type | It represents the main object type managed by the Common Plant Model (e.g. Valve, Mixer, Conveyor etc.) |
| CPM Node Template | It represents the template object that the user is able to reuse for CPM Node instances. It could represent simple (containing one CPM Node instance) as well as complex (containing hierarchically structured CPM Node Instances) objects (valve or packaging line template). |
| Functional Facet | Functional Facets enrich the CPM Node with functional aspects such as maintenance information, efficiency etc. |
| IOWA Runtime | Comprehends the runtime platform of IOWA |
| IPC | Inter Process Communication |
| MES | Manufacturing Execution System |
| OEE | Overall equipment effectiveness: OEE quantifies how well a manufacturing unit performs relative to its designed capacity and to the material produced, during the periods when it is scheduled to run. It is also referred as key performance indicator (KPI) |
| PIM | Process Image |
| RDF | Runtime Data Format used by IOWA to store the configuration data needed at runtime |
| Structure Facet | The structure facet is in charge of publishing the CPM Node interface and hiding the complexity of the CPM Node structure. |
| WCEE | Wiring Chart Execution Engine |

### Architectural Significant Requirements

The following table lists all architectural significant requirements.

**Table: Architectural Significant Requirements**

| **Title** | **Description** |
|---|---|
| Definition | The term "node" used to identify single object as well as objects that contain other objects. In the engineering system, it is possible to create user-defined properties to the CPM node type. A node has an Id (unique), a path (unique) and name (not unique) which is part of the path. |
| Scope | The common plant model includes information about all static elements of the plant that need to be exchanged between different components. Remarks: Static = lives longer than 1 day and is being defined by using engineering methods. The information is related to physical elements (Common Equipment Hierarchy) as well as conceptual elements (Common Master Data). |
| Hierarchy | The plant model is organized in a hierarchical fashion. It is possible to navigate through the hierarchy via browsing. It is possible to reference nodes via their hierarchy name. |
| Hierarchy name freely defineable | Components using the common plant model should not introduce constraints on this |
| | hierarchy name that could be in conflict with other components, node names itself don't have to be unique when the path name is unique. Example: For nodes Vessell/Outlet and Vessel 2/Outlet, the node name is duplicated but the path name is unique. The system shall support this situation. |
| Node types | In order to support reuse the CPM supports a type concept for nodes. |
| IDs as unchanging primary identifiers | As the path name of a node can be changing when moving it, the system shall keep a (non human-readable) unique object id that keeps the original reference especially with respect to historical data. |
| Nested node instances | Node instances may contain other node instances. When a node instance contains other node instance it can be considered as a folder. |
| Number of CPM elements | There isn't a hard coded limit in the SW regarding number of node type etc. |
| Engineering efficiency - Reuse of an hierarchical section | For engineering purpose a section of the hierarchical structure is reusable as a template in order to create and maintain multiple instances of a CPM items which are composed of several nodes spanning over several hierarchical levels. It shall be possible to propagate template changes to the already existing instances which are based on the template. |
| | Use case: |
| | In a plant there are 10 equal fillers. A filler in the CPM is composed by 5 CPM nodes. A configuration engineer creates the nodes defining the filler only once save it as a template and creates based on this template the 10 filler instances in the plant model. Changes in the template like e.g. adding a node (structural change) and changing a node's content can be applied to |
| | the already exiting instances which are based on the template. |
| Node data - Data types | The data of an node may contain members of type: |
| | - Simple data type (Boolean, Integer, Real, String, etc.) |
| | - Enumeration |
| | - Structure |
| | - Array |
| | - Reference to object |
| Node data - Nested data types | Array elements and structure elements may be again from type 'Simple data type', 'Structure' or 'Array' (nested types). |
| Node data - Access path | Dynamic data of a node is managed in the process image. The process image is considered to be an integral part of the CPM. This means addressing of tags shall be possible by using a nodes unique path + CPM leaf node name + element path. (e.g. Plant/Section-1/Unit-1/Aggregate-1/Pump- 1.Response.Measuring_point.Speed) It is possible to copy parts of the hierarchy without getting uniqueness errors. |
| Runtime collaboration | To enable runtime collaboration between two or more CPM servers, the data of a node may be retrieved from another CPM server and vice versa. |
| Instance specific data | In a real plant there are often nodes that partly differ from an already existing node types. E.g. a new unit has an additional flap than the original "Flap" object type. To avoid defining a completely new object type for this deviating kind of unit, the node (representing this unit) shall have optionally instance specific data and facets. Instance specific data and facets only exist at the object instance and not at the object type. Nevertheless changes at the object type shall still be propagated to the object instance even it this has object specific data. |
| | Instance specific data can optionally be taken over to the object type. |
| Facets - general | In order to support cross-versioning, CPM shall act as a repository and not include business logic. Facets of an object represent the usage of the object's data (e.g. alarming, archiving, audit, etc.) and can be attached or integrated to nodes (e.g. by an product like SCADA 2015). Facets can be used to expose the behavior of the node but the implementation of the behavior is not part of the Common Plant Model. Facets on a node are optional and defined within the configuration of the type/node. Logic for wiring of facets is not a problem and may be included with CPM. |
| Single repository for engineering | Engineering of a plant model is possible interchangeably by any engineering system of SCADA, DCS or MES independent whether the project starts as DCS, SCADA or MES project. There is no necessity for entering data twice or for synchronizing different repositories. This requirement can be fulfilled best by using a single repository for engineering data without forcing each product to adopt the same language natively. |
| Single repository for runtime | For a single (non-distributed system) there exists a single repository for the common plant model at runtime, independent whether the project starts as DCS, SCADA or MES project. The intention of this requirement is |
| | a) to avoid duplication of data in different parts of the runtime and subsequent potential inconsistencies, and |
| | b) to avoid synchronization overhead that could result if information (e.g. concerning the same node) is spread across several repositories. |
| Client notification | It is possible for components to register for certain objects in order to get notified of runtime changes of dynamic properties or of engineering changes of static properties. |
| System Type protection | The system shall distinguish between system defined node types (types that come with a system library or with a component) and user defined node types. |
| | It is possible to customize system defined node types by adding user defined properties. It is also possible to add user defined node types. It isn't possible to change system defined object types (the only exceptions are the user defined properties), to delete system defined object types or to modify system defined properties. |
| General types protection | It is possible to add protection flag to node types in order to forbid node type modification. |
| Runtime type support | The common plant model supports types at runtime. That means that a configuration change on a single node type only forces the engineering system to update one single object (the type object) at the runtime system. The subsequent updates of the node instances are executed on the runtime system. |
| Properties with dynamic values | Nodes can have dynamic properties where the values change at runtime such as e.g. process values, operator input values or calculation results. Dynamic properties shall have a timestamp (referring to time of last change) and a quality code (quality code only for tags). |
| Properties with static values | Nodes can have static properties with values defined during engineering / online delta download. When downloading changed static properties of an object, dynamic attribute values shall not get lost. |
| User and system defined node types | There are user defined node types which are created during configuration and predefined system maintained node types (e.g. coming from global or project library). |
| System / user defined properties | In the engineering the system distinguishes between predefined and user defined properties. For this reason a reference to the "base" system type must be kept inside the modified node type. |
| Schema driven for equipment description | A schema based description of the common plant model shall allow equipment type descriptions (meta data). The schema shall apply to types, type relations and type properties. It is possible to retrieve information about a type including its customization from the schema. The schema is also used for description of export / import file formats. |
| Schema driven versioning | A schema based description of the common plant model shall include a version information of the common plant model (meta data). The schema version information includes in the export / import file formats. |
| Upgradable | It is possible to upgrade the system maintained part of the common plant model to a new version without affecting the customized properties. |
| Transactional delta change | In the scope of CPM it is possible to create, modify or delete a node at runtime. The modification must be consistent inside one node. Processing (like e.g. execution of calculations or component methods) for node that is currently being changed is stopped in order to avoid inconsistencies. Clients that have registered for parameterization changes of this node are notified. |
| Hot standby redundancy | The common plant model supports a hot standby redundancy scheme that supports engineering changes at runtime (consistent online delta download) as well as delta synchronization of dynamic properties. During a redundancy failover, double processing of the same change events for dynamic properties shall be prevented via checking the timestamp of the last change. A calculation shall not be executed again if the timestamp of the result attribute indicates that it has already been done. |
| Transparent distribution | Within the context of one engineering system, it is possible to distribute the common plant model across different servers. For clients, this distribution is transparent. This means that any client can access plant model data on any server. |
| Cascading | It is possible to cascade common plant models that have been engineered independently. This means that individual installations / plant models can be integrated into a larger model. This can be done with remodeling (remapping) or via simple replication of information. |
| | Note: As the individual parts of the cascaded system continue to work unchanged, cascading typically involves duplication of information in the different engineering context of the higher level system. |
| User rights & roles | The system controls user access to objects in the common plant model. The access control is object granular. Runtime access rights: read / write. Engineering access rights: read / update / create / delete. If there is a primary node hierarchy defined in engineering, access rights can be inherited by lower level nodes from higher level nodes. |
| Node related version ID | Each node instance in the common plant model automatically gets a new system maintained version number after any engineering change / download. This version number links the runtime representation of the node to the engineering data. It can be used to make a consistency check whether current runtime and current engineering version are really the same. |
| Version labels for multiple objects | The user can define a version label for a selection of nodes. This label can be used to retrieve the individual node versions from the version repository in the engineering system. This is implemented similar to version labels as used in source code control systems. |
| Consistency check | In case of offline engineering, the system provides the possibility to compare runtime node versions with engineering node versions in order to ensure that they match. |
| Customization | Step 1: Customization of plant model via customizing node types. |
| | A set of customized node types can be collected in a library. |
| | Step 2: Creation of plant hierarchy / instantiation of nodes |
| Engineering libraries | Libraries can be handled independent of project (export / import). The engineering system can distinguish between a global library and a project related library. A new system release can come with a new global library - installation of this release shall not affect the project related library |
| Additional plant hierarchies | The system supports multiple hierarchies. That means a single node can be related to multiple hierarchies with different address path. |
| Mobile equipment | The system supports movable equipment that means an equipment can be associated to different location in the plant. A "Movable equipment" has the same properties/features as a static node (e.g. Name, Description, Attributes, Facets, etc.). In addition to "fixed equipment properties" mobile equipment provides a unique readable identifier that does not belong to the location where the mobile equipment is located. Mobile equipment is represented in the hierarchical view (like the static ones) in the current location. |
| Changes regarding hierarchical structure | Engineering changes in the hierarchy like adding/deleting/modifying/moving nodes does not result in any engineering effort regarding the subordinated nodes/objects in the hierarchy (e.g. no manually renaming of objects, alarm sources etc.). E.g. when moving a node in a hierarchy, all the sub-nodes are also moved. Any references between nodes remain unaffected. Moving a node from a position to another in a hierarchy will not affect the relation of the node in other hierarchies. |
| Inconsistent changes | Inconsistencies resulting from object/node changes in the engineering (e.g. deleting data used by other objects) are checked and reported by the engineering system. Note: Of course this applies only, if the engineering system cannot avoid the inconsistency early on. |
| Approval of changes | Applying of changes in types/instances needs to be optionally approved by configuration engineer in the engineering system. |
| Engineering - general | Engineering allows to define object types, add, alter and remove object type properties, instantiate objects from objects types, add, alter, remove instance specific object properties, define a hierarchical plant model. |
| Engineering approach | There are different approaches to creating a plant model: |
| | - Top Down (typical in DCS): Plant Model is created synchronously with the automation; |
| | - Bottom Up: Several independently engineered units are combined to form the plant, but no extra modeling involved (not a real MES case) |
| | - Bottom Up + Top down (typical in SCADA): Several independently engineered units are integrated into a top down engineered plant model. |
| Node data | In the engineering system, it is possible to create user-defined properties to the CPM node type. These properties are optionally checked for uniqueness in engineering. Properties marked for uniqueness cannot be changed at runtime. |
| Node data constrains | These properties are optionally checked for constraints like range checks. Details to be defined. |
| Decorator for equipment parameter | It is possible to define a MES relevant-flag for SCADA parts of CPM to be able to filter the automation facets for MES-relevant parts only. |
| Dynamic or static parameters | CPM gives the possibility to set if a property value can be modified or not during the execution. |
| | Static properties: value cannot be modified during runtime, example : tank's capacity, equipment's mobility; |
| | Dynamic properties: value can be modified during execution, example : quantity in the tank, sterilization status) |
| Persistency equipment parameters value | CPM gives the possibility to define if a parameter value has not to be permanently stored in CPM storage |
| Objects assignment | CPM is able to contain DPs/tags as well as additional objects such as screens. |
| Connection between CPM and screen hierarchy | It is possible to use the Common Plant model as screen topology. |
| Remote objects assignment from distribution point of view | CPM is able to access Objects of remote systems. Independently if remote systems comprise CPM or not. |
| CPM Distribution | CPM is distributed across several server nodes in a hierarchical organization. A system on the bottom of the hierarchy (for example a line) defines its own hierarchy. A top level system must be able to combine the bottom hierarchies into one, so there is a complete hierarchy available in the top level system |
| CPM Online Engineering | Hierarchy and nodes of the CPM can be created and changed during runtime. |
| Support of multiple hierarchies | It is possible to create more than one hierarchy. e.g. equipment hierarchy, screen hierarchy, device hierarchy |
| Interoperability | It is possible to import and map equipment types and nodes from third party system. E.g., The equipment is created starting from a model coming from ERP or PLM and further enhanced with SCADA/MES functions. |
| Access control | It is possible to define access rights for CPM by using user roles definition, e.g.: |
| | 1. no change of "remote" parts of the CPM |
| | 2. Read-only |
| | 3. Rights per tree |
| | 4. Rights per node; lower nodes inherit from nodes above, if they do not have their own permissions |
| Multi-language | Each node has a single-language name for identification, and a multi-language display name |
| Interface/Wrapper support | It is possible to define a wrapper between objects (e.g. valve) in the PLC and CPM, to be able to map different kind of implementations of one object in different PLCs/different projects) to one implementation model in the CPM to make standardization possible. |
| Data Access | Each system integrated in CPM is able to access data exposed by the other systems. |
| Equipment relationships | CPM provides the possibility to define and organize different relationships among nodes. The capability of organizing the equipment is not always based on a hierarchical structure. Other types of relationship must be taken into account. |
| | § Hierarchy |
| | § Graph |
| | § Group |
| Node graph relation specification | CPM provides functional properties so that each graph relationship among nodes can be further detailed, e.g. the connection between equipment can be plain or specialized with: |
| | § Capacity (e.g. a pipe flow specification etc.) |
| | § Behavior (e.g. FIFO, LIFO, FEFO, etc.) |
| | § Topology |
| Object definition | The user is able to specify additional system properties that characterize the node from a behavioral point of view. The CPM node can be defined as: |
| | § tool, |
| | § fixed equipment |
| | § movable equipment |
| | § shared equipment among more equipment |
| | § etc. |
| Nodes with and without automation relation | CPM gives the possibility to define nodes with and without automation relation |
| Versioning | CPM manages plant version to allow that all changes applied to the equipment structure are stored. This allows a better controlling the compatibility and upgrade of existing applications where the equipment has already been used. |
| Revision management | CPM provides the possibility to assign a revision number to one or more CPM nodes under editing to allow grouping and uniquely identify all changes. |
| Undoing of changes | CPM provides the possibility to undo object changes with reference to a specific revision number |
| Side by side deployment of CPM node types | CPM provides the possibility to apply type changes either to all instances or to a subset. |
| Process related constraints | CPM gives the possibility to define more than one constraint so that a runtime object cannot be modified or deleted. |
| Audit trail | CPM supports audit trail for actions or changes on the system. |
| Electronic logbook | CPM provides information on the equipment history. Manual entry into the logbook should also be possible. e.g. Production activities, maintenance activities, calibration activities, status changes. |
| CPM project type agnostic | It is possible to define physical objects within CPM either on green-field projects or brown-field projects., e.g.: |
| | § Greenfield Top Down with Siemens Portfolio (SCADA and MES done in meantime) |
| | § Greenfield Bottom Up with Siemens Portfolio (first SCADA then MES) |
| | § Brownfield Top Down with Siemens Portfolio (first SCADA then MES) |
| | § Brownfield Top Down 3rd Party SCADA (first SCADA then MES) |
| Interchangeable Engineering | Engineering of a plant model is possible interchangeable by any engineering system of SCADA, DCS or MES independent whether the project starts with SCADA, DCS or MES. |
| Hierarchy navigation | The CPM supports Hierarchy navigation starting from node |
| CPM supports SQL like query | The user is able to query CPM data (nodes, hierarchies, groups, graphs) including the current values in a relational way. Note: Queries support CNS-part in FROM (like already available in WinCC OA for dpGroups). This enables the restriction of query results (for current alarms and original values) to a part of the CNS-tree |
| Import automation facets | It is possible to import automation facets from TIA-portal, from OPC-server, and from 3^{rd}-party PLC engineering tools |

## Claims

1. A common plant model for modelling of physical plant items of a production plant within a manufacturing execution system having an engineering environment and a runtime environment, said common plant model comprising:
a) a node type model aggregating different aspects for the modelling of a single physical plant item involving public interface parameters as well as automation parameters;
b) a number of nodes, each representing an instance of a node type;
c) a library model comprising a project library and a global library, said libraries comprising a node type model, a facet model and a rule model as well as a hierarchy model,
d) a wiring chart model defining the interaction between interface members of different facets of a node; and
e) a graph model representing physical and/or logical connections between the nodes.

2. The common plant model according to claim 1, wherein the node type model comprises:
a) a header providing an identity information of the node type;
b) a structure facet for high level representation;
c) optionally an automation facet for automation representation;
d) optionally one or multiple functional facets for different functional aspects;
e) optionally one or multiple wiring charts defining the relationship between the facets of two node connected by a wire;
f) optionally one to multiple node views providing a view to node data exposed by the structure facet.

3. The common plant model according to claim 1 or 2, wherein the node types are defined for dedicated levels within defined hierarchies.

4. The common plant model according to claim 3 wherein one or multiple hierarchy levels are assigned to a node type, thereby enabling guidance in an engineering system to create nodes in a hierarchy at an intended level.

5. The common plant model according to any of the preceding claims wherein the node types are defined in the libraries are comprise attributes that are consumed by external applications, used for data representation or for implementing business logic.
